# EUROPEAN PATENT APPLICATION

(11) **EP 4 611 026 A1**
(43) Date of publication of application: **03.09.2025**
(21) Application number: 24159970.3
(22) Date of filing: 27.02.2024
(51) Int. Cl.: H01L 21/67

(54) **AIR BEARING FOR WAFER FOIL STRETCHING**

(71) Applicant: Nexperia B.V., 6534 AB Nijmegen (NL)
(72) Inventor: Huybers, Ralph, 6534AB Nijmegen (NL)
(74) Representative: Pjanovic, Ilija

(57) **Abstract**

Aspects of the present disclosure relate to a method for stretching a wafer foil that is held by a film frame carrier and on which a plurality of electronic components is arranged. Aspects of the present disclosure further relate to a method for transferring an electronic component. Further aspects of the present disclosure further relate to a device for stretching a wafer foil that is held by a film frame carrier and on which a plurality of electronic components is arranged, and to a pick- and-place apparatus for transferring an electronic component.

For stretching the wafer foil, the film frame carrier is tensioned over a tensioning member by mutually moving the tensioning member and the film frame carrier.

According to an aspect of the present disclosure, an air bearing is generated in between the wafer foil and the tensioning member at least during a part of the mutual movement of the film frame carrier and the tensioning member.

## Description

### FIELD

Aspects of the present disclosure relate to a method for stretching a wafer foil that is held by a film frame carrier and on which a plurality of electronic components is arranged. Aspects of the present disclosure further relate to a method for transferring an electronic component. Further aspects of the present disclosure further relate to a device for stretching a wafer foil that is held by a film frame carrier and on which a plurality of electronic components is arranged, and to a pick-and-place apparatus for transferring an electronic component.

### BACKGROUND

In semiconductor assembly, electronic components such as semiconductor dies often need to be transported between a source substrate and a target substrate. For example, the source substrate may comprise a diced or structured semiconductor wafer and the target substrate may comprise a printed circuit board on which one or more of the dies on the diced semiconductor wafer need to be arranged. To enable such transfer, a system for transporting an electronic component is used. Such systems may also be referred to as a pick-and-place apparatus or die placement apparatus, such as a die bonder or die sorter.

Such pick-and-place apparatuses are configured to receive a film frame carrier, that holds a diced or structured semiconductor wafer. For the apparatus to be able to pick up a die, it is needed that the die is separated enough from its neighboring dies. To create such a gap between the dies, wafer foil stretching is applied. As the diced or structured semiconductor wafer is provided on a foil, this foil can be stretched to increase the gap between the dies. If the gap between the dies is too small, there is a risk that when a die is picked up, that die or any of the neighboring dies become damaged.

### SUMMARY

An aspect of the present disclosure is to lower the risk of dies getting damaged during the pick-and-place process and to increase yield.

According to a first aspect of the disclosure, this object has been achieved by providing a method for stretching a wafer foil that is held by a film frame carrier and on which a plurality of electronic components is arranged. The method comprises stretching the wafer foil over a tensioning member by mutually moving the film frame carrier and the tensioning member to thereby increase a distance between adjacent electronic components. The method furthermore comprises passing a gaseous medium between the tensioning member and wafer foil at least during a part of the mutual movement of the film frame carrier and the tensioning member.

Mutually moving the film frame carrier and the tensioning member may comprise moving the film frame carrier, or a holding member that holds the film frame carrier, while keeping the tensioning member stationary, or moving the tensioning member while keeping the film frame carrier stationary. In other embodiments, both the film frame carrier and tensioning member are moved.

In prior art systems, the wafer foil will directly contact the tensioning member during the stretching of the wafer foil. As a result, friction between the wafer foil and the tensioning member occurs that limits the amount of stretching that can be imparted to the wafer foil.

According to the present disclosure, a gas medium is passed in between the tensioning member and the wafer foil. This will create a form of an air bearing that provides little frictional force between the tensioning member and the wafer foil. Accordingly, the wafer foil can be stretched further and more efficiently.

The tensioning member may comprise a protruding portion, and the film frame carrier may comprise a ring-like frame in which the wafer foil is held. Stretching the wafer foil over the tensioning member may then comprise mutually moving the film frame carrier and the tensioning member such that the protruding portion protrudes the ring-like frame.

The protruding portion may have a front surface that faces the wafer foil during stretching and a side surface connected to the front surface. Mutually moving the film frame carrier and the tensioning member may comprise moving the ring-like frame along the side surface while the front surface faces the wafer foil.

The front surface may be substantially flat. Mutually moving the film frame carrier and the tensioning member may comprise moving at least one of the film frame carrier and the tensioning member along a first direction. The front surface may be at least substantially perpendicular to the first direction. The side surface may extend substantially parallel to the first direction.

Passing the gaseous medium between the tensioning member and the wafer foil may comprise passing the gaseous medium at least between the side surface and the wafer foil. In some embodiments, the gaseous medium is passed between the front surface and the wafer foil and between the side surface and the wafer foil. In other embodiments, the gaseous medium is passed only between the side surface and the wafer foil or only between the front surface and the wafer foil.

Passing the gaseous medium between the tensioning member and the wafer foil may comprise blowing or otherwise ejecting the gaseous medium out of the tensioning member. Such blowing or ejecting may comprise blowing or ejecting the gaseous medium at an edge between the side surface and the front surface, and/or blowing or ejecting the gaseous medium at the side surface. Blowing or ejecting may additionally comprise blowing or ejecting the gaseous medium through a plurality of openings or pores in the tensioning member.

The tensioning member may comprise one or more channels that are connected to the plurality of openings or pores. Blowing or ejecting the gaseous medium may then comprise controlling a flow of the gaseous medium through the one or more channels and/or controlling a pressure of the gaseous medium in the one or more channels using a valve.

The tensioning member may furthermore comprise an abutment surface. Controlling the flow and/or pressure of the gaseous medium using the valve may then comprise stopping the flow of gaseous medium when the film frame carrier, or a holding member that holds the film frame carrier, abuts or is about to abut or is close to the abutment surface. In some embodiments, mechanical contact between the film frame carrier, or the holding member that holds the film frame carrier, and the abutment surface triggers operation of the valve, i.e., closing or opening the valve. In other embodiments, the valve may have an operating member that protrudes from the abutment surface. Controlling the flow and/or pressure of the gaseous medium using the valve may then comprise stopping the flow of gaseous medium through engagement between the film frame carrier, or the holding member that holds the film frame carrier, and the operating member.

Alternatively, the method may comprise measuring an extent of the mutual movement between the tensioning member and the film frame carrier and controlling the valve when the extent of the mutual movement has exceeded a predetermined threshold.

According to a second aspect of the present disclosure, a method for transferring an electronic component is provided. The method comprises providing a film frame carrier that holds a wafer foil on which a plurality of electronic components is arranged, stretching the wafer foil in accordance with the previously described method to thereby increase a distance between the adjacent electronic components, picking up an electronic component from the wafer foil, and arranging the electronic components that has been picked up on a target substrate.

According to a third aspect of the present disclosure, a device for stretching a wafer foil that is held by a film frame carrier and on which a plurality of electronic components is arranged is provided. The device comprises a first holding member for holding the film frame carrier, a tensioning member, a drive for mutually moving the first holding member and the tensioning member, and a bearing member for passing a gaseous medium between the tension member and wafer foil.

The tensioning member may comprise a protruding portion. The film frame carrier may comprise a ring-like frame in which the wafer foil is held or configured to be held. The protruding portion may be configured to protrude the ring-like frame.

The protruding portion may have a front surface configured to face the wafer foil during stretching and a side surface connected to the front surface. The film frame carrier and the tensioning member may be configured to mutually move along a first direction. The front surface may preferably be substantially flat and at least substantially perpendicular to the first direction. The side surface may preferably extend substantially parallel to the first direction.

The tensioning member may comprise a plurality of openings or pores through which the gaseous medium can be ejected or blown. The openings or pores may be formed at an edge between the side surface and the front surface, and/or at the side surface. Additionally, or alternatively, the tensioning member may comprise an end part arranged at an end of the protruding portion, wherein the plurality of openings or pores are provided in the end part. Such end part can be made of porous material or it can be provided with a plurality of manufactured openings.

The tensioning member may comprise one or more channels that are connected to the plurality of openings or pores. The device may further comprise a valve for controlling a flow of the gaseous medium through the one or more channels and/or a pressure of the gaseous medium in the one or more channels.

The device may further comprise a controller and a measurement device, such as an encoder, for measuring an extent of the mutual movement between the tensioning member and the film frame carrier. The controller may be configured to control the valve when the extent of the mutual movement has exceeded a predetermined threshold or when the film frame carrier or the first holding member abuts an abutment surface of the tensioning member.

Alternatively, the device may comprise an abutment surface, a sensor for sensing contact between the abutment surface and the first holding member or the film frame carrier, and a controller, wherein the controller is configured to control the valve when contact between the abutment surface and the first holding member or the film frame carrier has been sensed.

Alternatively, the valve may have an operating member for operating the valve. The valve may be configured to stop the flow of the gaseous medium through engagement between the film frame carrier or the first holding member and the operating member. The operating member may preferably extend away from an abutment surface of the tensioning member. The abutment surface may preferably be configured to allow the film frame carrier or the first holding member to abut there against at an end of the mutual movement of the tensioning member and the film frame carrier.

According to a fourth aspect of the present disclosure, a pick-and-place apparatus for transferring an electronic component is provided. The pick-and-place apparatus comprises the stretching device as previously defined and a pick-up tool configured to pick up an electronic component from the wafer foil and for arranging the electronic component that has been picked up on a target substrate.

In the methods and devices described above, the gaseous medium may comprise air, nitrogen, or an inert gas such as Argon.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 illustrates a detailed view of an embodiment of a pick-and-place apparatus according to the present disclosure;
Figure 2 illustrates a wafer foil that is held by a film frame carrier and that can be arranged in the pick-and-place apparatus of figure 1;
Figure 3 illustrates a cross section of the wafer foil of figure 2;
Figure 4 illustrates a detailed view of a device for stretching a wafer foil that is held by a film frame carrier according to the present disclosure;
Figure 5 illustrates the device of figure 4 during the early stages of stretching the wafer foil;
Figure 6 illustrates the device of figure 4 when fully stretching the wafer foil;
Figure 7 illustrates the device of figure 4 when returning to its starting position; and
Figure 8 illustrates a method for transferring an electronic component in accordance with an aspect of the present disclosure.

### DETAILED DESCRIPTION

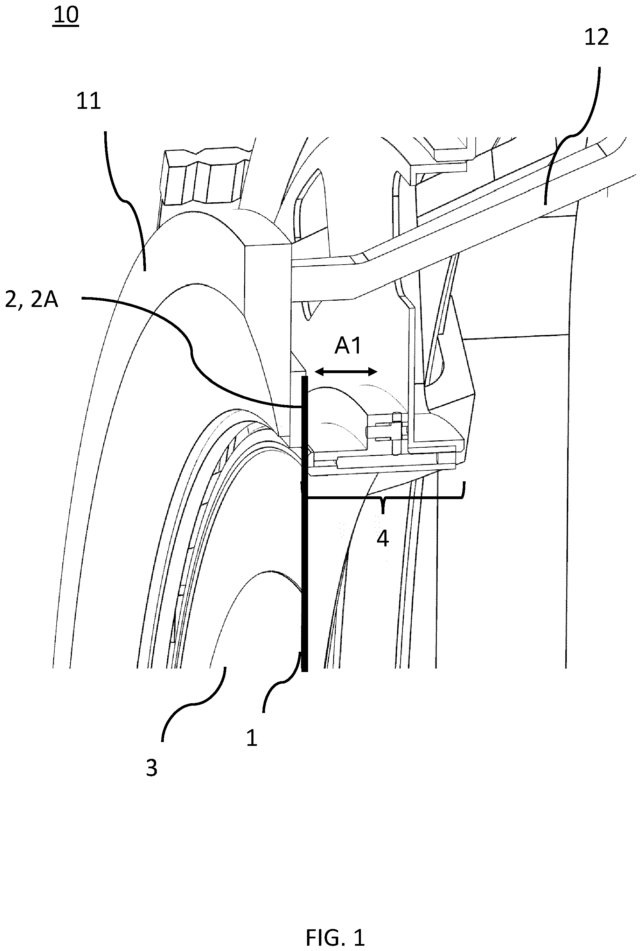

Figure 1 shows a detailed view of a pick-and-place apparatus 10 comprising a device for stretching a wafer foil 1 on which a diced semiconductor wafer 3 is arranged in accordance with an aspect of the present disclosure.

Pick-and-place apparatus 10 is configured to transfer a semiconductor die arranged on wafer foil 1, which is typically transparent. To this end, pick-and-place apparatus comprises a pick-up tool that is configured to pick up the semiconductor die from wafer foil 1 and to arrange the semiconductor die that has been picked up on a target substrate. The pick-up tool is known in the art and may comprise a vacuum nozzle.

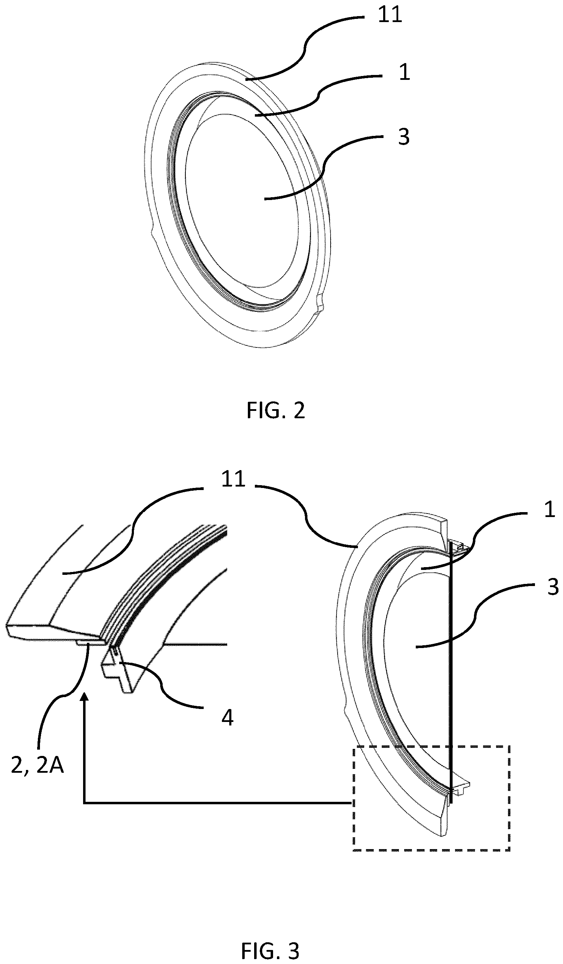

Now also referring to figures 2 and 3, the device for stretching wafer foil 1 comprises a first holding member 11, which can be ring-like shaped. First holding member 11 is configured to be releasably coupled to a film frame carrier 2 that holds wafer foil 1. For example, first holding member 11 is coupled to film frame carrier 2 using locks or the like. Film-frame carrier 2 comprises a ring-shaped frame 2A to which wafer foil 1 is mounted.

Figure 2 illustrates a diced semiconductor wafer 3 arranged on a wafer foil 1 that comprises a plurality of semiconductor dies. Instead of a diced semiconductor wafer 3, a structured semiconductor wafer may be used.

Now referring to figure 1, first holding member 11 is coupled to a drive by means of bars 12. Using the drive, first holding member 11 can be moved along a direction indicated by arrow A1 towards or away from a tensioning member 4. The drive may comprise a rotational or linear motor, or a pneumatic or hydraulic cylinder. It is noted that the drive used for imparting the relative motion between tensioning member 4 and first holding member 11 is known in the art.

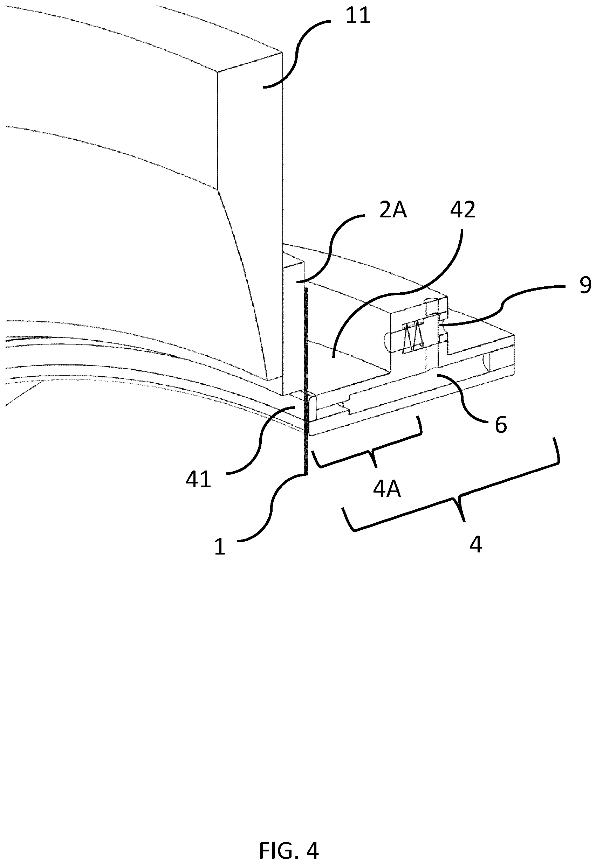

As shown in figure 4, tensioning member 4 comprises a protruding portion 4A that has a front surface 41 that is configured to face wafer foil 1 and a side surface 42 that is connected to front surface 41.

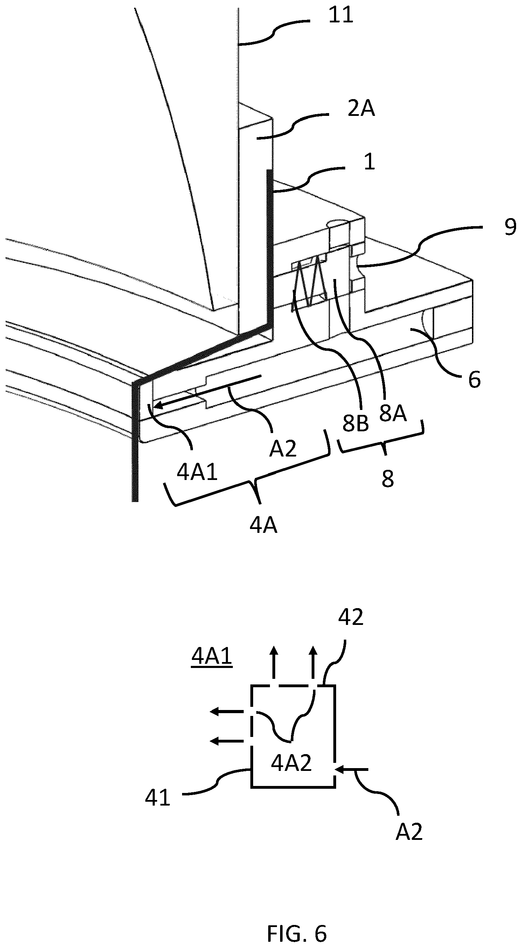

According to an aspect of the present disclosure, the device for stretching wafer foil 1 comprises a bearing member configured to pass a gaseous medium between tensioning member 4 and wafer foil 1. The bearing member is shown in more detail in figure 6. It may comprise a plurality of openings provided at an end of protruding portion 4A and facing wafer foil 1. As an example, the bearing member may be formed using a porous part 4A1 that at least partially defines front surface 41 and side surface 42. Porous part 4A1 is provided with a plurality of pores 4A2 exiting on front surface 41 and side surface 42 for allowing gaseous medium that is provided thereto according to arrow A2 to be passed in between porous part 4A1 and wafer foil 1 thereby preventing or limiting physical contact between protruding portion 4A and wafer foil 1.

Instead of using porous part 4A1, a part of non-porous material can be used in which a plurality of openings is provided for allowing gaseous medium to pass through. Again, the openings are provided on front surface 41 and/or side surface 42.

The abovementioned openings or pores 4A2 are in fluid communication with a channel 6 formed inside tensioning member 4. A gaseous medium can be supplied to channel 6 through an inlet 9. The gaseous medium may for example comprise air, Nitrogen, Argon, or the like.

Tensioning member 4 may comprise a valve 8 for controlling a flow or pressure of gaseous medium through or in channel 6. Valve 8 may comprise a valve body 8A and a valve spring 8B. Using valve spring 8B, valve body 8A is spring-biased such that it closes off a passage between inlet 9 and channel 6. Valve 8 can be opened by providing pressurized gaseous medium to inlet 9. As a result of the applied pressure, valve body 8A will be moved against the spring bias to a position in which it opens the passage between inlet 9 and channel 6. Consequently, the gaseous medium will be released through pores 4A2 in between wafer foil 1 and tensioning member 4.

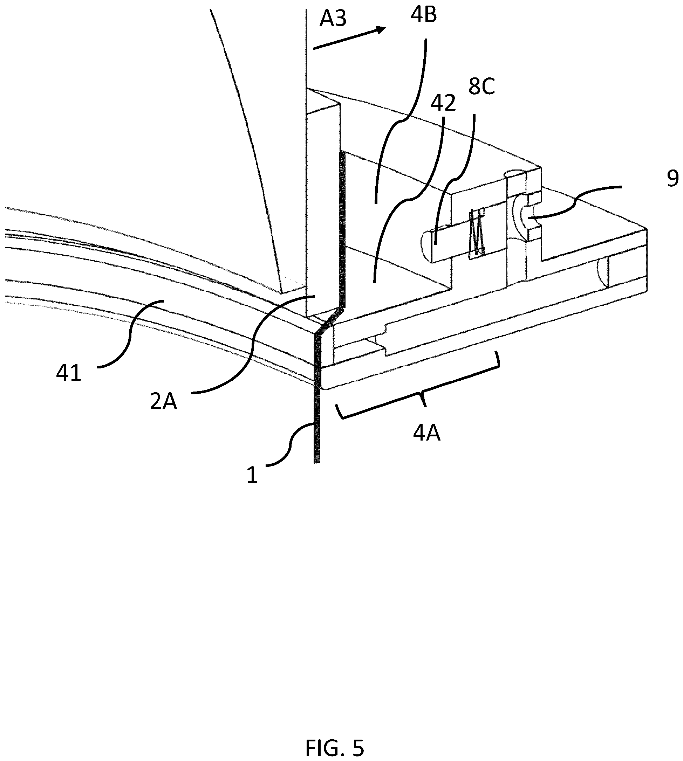

As shown in figure 5, valve 8 has an operating member 8C for operating valve 8 that extends away from an abutment surface 4B of tensioning member 4 when valve 8 is in the position in which it opens the passage between inlet 9 and channel 6. As will be explained next, operating member 8C can be used for operating valve 8 by means of mechanical contact between operating member 8C and film frame carrier 2 or first holding member 11.

A method for stretching wafer foil 1 that is held by film frame carrier 2 will now be described referring to figures 4-7.

Figure 4 shows an initial position in which no pressurized gas is supplied to inlet 9. Furthermore, tensioning member 4 and first holding member 11 are relatively far apart, and valve body 8A is in a position in which it closes off the passage between inlet 9 and channel 6.

In a next step, shown in figure 5, pressurized gaseous medium is supplied to inlet 9 thereby opening valve 8 and causing operating member 8C to protrude from abutment surface 4B, while at substantially the same time, first holding member 11 is driven by the drive to move in accordance with arrow A3. By applying the pressurized gaseous medium, an air bearing is created in between tensioning member 4 and wafer foil 1. When moving first holding member 11 towards tensioning member 4, protruding portion 4A protrudes ring-like frame 2A of film frame carrier 2.

Due to the created air bearing, friction between side surface 42 and wafer foil 1 and/or between front surface 41 and wafer 1 is reduced. The reduced friction allows more of the force exerted on first holding member 11 to become available for stretching wafer foil 1. As a result of this increase in force, the semiconductor dies on wafer foil 1 are spread farther apart than without the flow of gaseous medium.

When first holding member 11 is moved further along arrow A3, it will at some time abut abutment surface 4B as shown in figure 6. At the same time, first holding member 11, or film frame carrier 2, will push protruding portion 8C of valve 8 so that valve body 8A closes off the passage between inlet 9 and channel 6. This will stop the flow of gaseous medium. In this position, the semiconductor dies are spread apart the farthest. Furthermore, in this position, the semiconductor dies will be picked from wafer foil 1.

In figure 6, first holding member 11 or film frame carrier 2 abuts abutment surface 4B. This contact defines the end stroke of first holding member 11. At the same time, the contact between first holding member 11 or film frame carrier 2 and operating member 8C, which may occur even before the end stroke is reached, triggers turning off of valve 8. Other embodiments are possible to achieve these same effects. For example, a measurement device, such as an encoder, can be used to determine the stroke of first holding member 11. Once it has been determined, for instance using a controller and using the measurements of the measurement device, that the stroke has reached a predefined threshold, the movement of first holding member 11 can be stopped and valve 8 can be closed. In other embodiments, a mechanical stop is used to determine the end stroke of first holding member 11 similar to abutment surface 4B. However, in these embodiments, it is determined whether first holding member 11 or film frame carrier 2 contacts the mechanical stop, e.g., using a sensor, and based on this determination, valve 8 is closed.

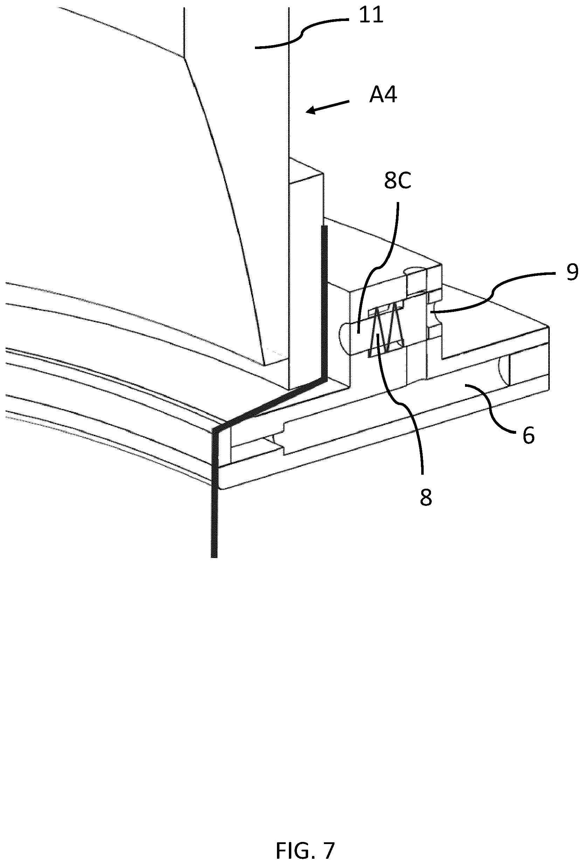

Figure 7 illustrates the step of returning to the initial position of figure 4. During this step, first holding member 11 is moved in accordance with arrow A4 by the drive and air may be optionally evacuated from inlet 9. During this motion, valve body 8A closes off the passage between channel 6 and inlet 9.

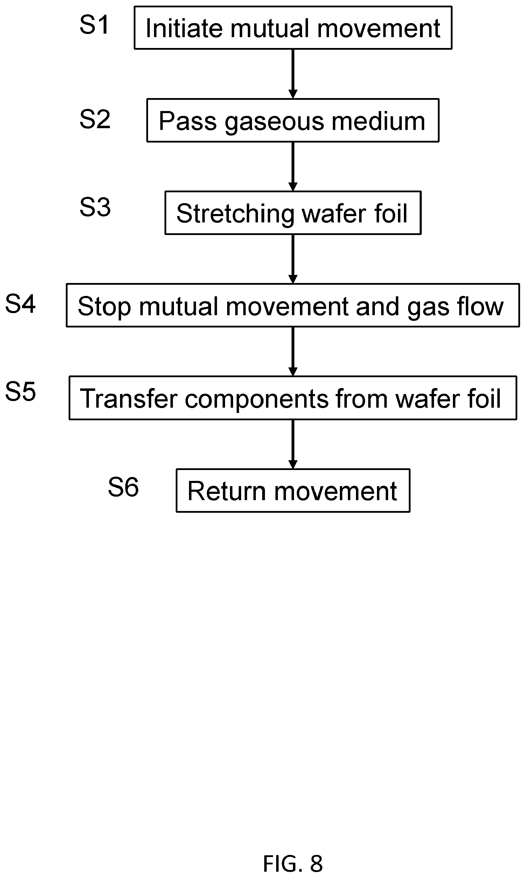

Figure 8 illustrates a method for transferring an electronic component in accordance with an aspect of the present disclosure. In this method, a film frame carrier is provided which holds a wafer foil on which a plurality of electronic components is arranged. In addition, a target substrate is provided onto which the electronic components are to be arranged.

The method starts in step S1 by mutually moving the film frame carrier and a tensioning member. In step S2, a gaseous medium is passed between the tensioning member and wafer foil at least during a part of the mutual movement of the film frame carrier and the tensioning member. At a moment in time, indicated as step S3, the tensioning member will contact the wafer foil thereby stretching the wafer foil and increasing a distance between adjacent electronic components on the wafer foil.

In step S4, the mutual movement of the tensioning member and the film frame carrier and the passing of gaseous medium is stopped. Thereafter, in step S5, an electronic component is picked up from the wafer foil, for example using a vacuum nozzle, and is arranged on the target substrate. This can be repeated until a desired number of electronic components has been transferred. As a final step S6, the tensioning member and the film frame carrier are mutually moved to return to their initial positions. Typically, the mutual movement performed during steps S1 and S6 comprises moving the film frame carrier, for example by moving a holding member to which the film frame carrier is coupled, while keeping the tensioning member stationary. However, the present disclosure is not limited thereto.

The scope of the present disclosure includes any novel feature or combination of features disclosed therein either explicitly or implicitly or any generalization thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

The term "comprising" does not exclude other elements or steps, the term "a" or "an" does not exclude a plurality. Reference signs in the claims shall not be construed as limiting the scope of the claims.

## Claims

1. A method for stretching a wafer foil that is held by a film frame carrier and on which a plurality of electronic components is arranged, comprising:
stretching the wafer foil over a tensioning member by mutually moving the film frame carrier and the tensioning member to thereby increase a distance between adjacent electronic components; and
passing a gaseous medium between the tensioning member and wafer foil at least during a part of the mutual movement of the film frame carrier and the tensioning member.

2. The method according to claim 1, wherein the tensioning member comprises a protruding portion, wherein the film frame carrier comprises a ring-like frame in which the wafer foil is held, wherein said stretching the wafer foil over the tensioning member comprises mutually moving the film frame carrier and the tensioning member such that the protruding portion protrudes the ring-like frame.

3. The method according to claim 2, wherein the protruding portion has a front surface that faces the wafer foil during stretching and a side surface connected to the front surface;
wherein said mutually moving the film frame carrier and the tensioning member comprises moving the ring-like frame along the side surface while the front surface faces the wafer foil;
wherein, preferably, the front surface is substantially flat and wherein said mutually moving the film frame carrier and the tensioning member comprises moving at least one of the film frame carrier and the tensioning member along a first direction, wherein the front surface is at least substantially perpendicular to the first direction, wherein the side surface more preferably extends substantially parallel to the first direction.

4. The method according to claim 3, wherein said passing the gaseous medium between the tensioning member and the wafer foil comprises passing the gaseous medium at least between the side surface and the wafer foil.

5. The method according to claim 3 or 4, wherein said passing the gaseous medium between the tensioning member and the wafer foil comprises blowing or otherwise ejecting the gaseous medium out of the tensioning member.

6. The method according to claim 5, wherein said blowing or ejecting comprises blowing or ejecting the gaseous medium at an edge between the side surface and the front surface, and/or blowing or ejecting the gaseous medium at the side surface.

7. The method according to claim 6, wherein said blowing or ejecting comprises blowing or ejecting the gaseous medium through a plurality of openings or pores in the tensioning member.

8. The method according to claim 7, wherein the tensioning member comprises one or more channels that are connected to the plurality of openings or pores, wherein said blowing or ejecting the gaseous member comprises controlling a flow of the gaseous medium through the one or more channels and/or controlling a pressure of the gaseous medium in the one or more channels using a valve;
wherein the tensioning member preferably comprises an abutment surface, said controlling the flow and/or pressure of the gaseous medium using the valve comprising stopping the flow of the gaseous medium when the film frame carrier, or a holding member that holds the film frame carrier, abuts or is about to abut or is close to the abutment surface, wherein the valve preferably has an operating member that protrudes from the abutment surface, said controlling the flow and/or pressure of the gaseous medium using the valve comprises stopping the flow of the gaseous medium through engagement between the film frame carrier, or the holding member that holds the film frame carrier, and the operating member; or
wherein the method further comprises measuring a mutual movement of the film frame carrier, or a holding member that holds the film frame carrier, and the tensioning member, the method further comprising stopping the flow of the gaseous medium and/or stopping the mutual movement when the mutual movement has exceeded a predetermined threshold.

9. A method for transferring an electronic component, comprising:
providing a film frame carrier that holds a wafer foil on which a plurality of electronic components is arranged;
stretching the wafer foil in accordance with any of the previous claims to thereby increase a distance between the adjacent electronic components;
picking up an electronic component from the wafer foil; and
arranging the electronic components that has been picked up on a target substrate.

10. A device for stretching a wafer foil (1) that is held by a film frame carrier (2) and on which a plurality of electronic components is arranged, comprising:
a first holding member (11) for holding the film frame carrier;
a tensioning member (4);
a drive for mutually moving the first holding member and the tensioning member;
a bearing member for passing a gaseous medium between the tensioning member and wafer foil at least during a part of the mutual movement of the film frame carrier and the tensioning member.

11. The device according to claim 10, wherein the tensioning member comprises a protruding portion (4A), wherein the film frame carrier comprises a ring-like frame (2A) in which the wafer foil is held or configured to be held, wherein the protruding portion is configured to protrude the ring-like frame.

12. The device according to claim 11, wherein the protruding portion has a front surface (41) configured to face the wafer foil during stretching and a side surface (42) connected to the front surface;
wherein the film frame carrier and the tensioning member are configured to mutually move along a first direction, wherein the front surface is preferably substantially flat and at least substantially perpendicular to the first direction; and
wherein the side surface preferably extends substantially parallel to the first direction.

13. The device according to claim 12, wherein the tensioning member comprises a plurality of openings or pores (4A2) through which the gaseous medium can be ejected or blown;
wherein the openings or pores are preferably formed at an edge between the side surface and the front surface, and/or at the side surface; and/or
wherein the tensioning member comprises an end part arranged at an end of the protruding portion, wherein the plurality of openings or pores are provided in the end part.

14. The device according to claim 13, wherein the tensioning member comprises one or more channels (6) that are connected to the plurality of openings or pores, and wherein the device further comprises a valve (8) for controlling a flow of the gaseous medium through the one or more channels and/or a pressure of the gaseous medium in the one or more channels;
wherein, preferably:
the device further comprises a controller and a measurement device, such as an encoder, for measuring an extent of the mutual movement between the tensioning member and the film frame carrier, the controller being configured to control the valve when the extent of the mutual movement has exceeded a predetermined threshold; or
the device comprises an abutment surface, a sensor for sensing contact between the abutment surface and the first holding member (11) or the film frame carrier (2), and a controller, wherein the controller is configured to control the valve when contact between the abutment surface and the first holding member (11) or the film frame carrier (2) has been sensed; or
the valve has an operating member (8C) for operating the valve, wherein the valve is configured to stop the flow of the gaseous medium through engagement between the film frame carrier or first holding member and the operating member, wherein the operating member preferably extends away from an abutment surface (4B) of the tensioning member, said abutment surface preferably being configured to allow the film frame carrier or the first holding member to abut there against at an end of the mutual movement of the tensioning member and the film frame carrier.

15. A pick-and-place apparatus (10) for transferring an electronic component, comprising:
the stretching device according to any of the claims 10-14; and
a pick-up tool configured to pick up an electronic component from the wafer foil and for arranging the electronic component that has been picked up on a target substrate.
